Europäisches Patentamt

(19) European Patent Office

Office européen des brevets

(11) Numéro de publication : **0 325 525 B1**

# (12) FASCICULE DE BREVET EUROPEEN

(45) Date de publication du fascicule du brevet :
08.05.91 Bulletin 91/19

(51) Int. Cl.⁵ : **H01L 31/02**

(21) Numéro de dépôt : **89400130.4**

(22) Date de dépôt : **17.01.89**

(54) **Capteur d'image à faible encombrement.**

(30) Priorité : **22.01.88 FR 8800679**

(43) Date de publication de la demande :
**26.07.89 Bulletin 89/30**

(45) Mention de la délivrance du brevet :
**08.05.91 Bulletin 91/19**

(84) Etats contractants désignés :
**DE FR GB NL**

(56) Documents cités :
**FR-A- 2 565 408**
**PATENT ABSTRACTS OF JAPAN, vol. 7, no.
123 (E-178)[1268], 27 mai 1983, page 44 E 178;
& JP-A-58 40 870 (SANYO DENKI K.K.) 09-
03-1983**

(56) Documents cités :
**PATENT ABSTRACTS OF JAPAN, vol. 8, no.
139 (E-253)[1576], 28 juin 1984, page 20 E 253;
& JP-A-59 47 774 (FUJI DENKI K.K.) 17-03-1984
PATENT ABSTRACTS OF JAPAN, vol. 7, no.
214 (E-199)[1359], 21 septembre 1983, page
135 E 199; & JP-A-58 107 788 (MITSUBISHI
DENKI K.K.) 27-06-1983**

(73) Titulaire : **THOMSON-CSF**
**51, Esplanade du Général de Gaulle**
**F-92800 Puteaux (FR)**

(72) Inventeur : **Prost, Roger**
**THOMSON-CSF SCPI 19, avenue de Messine**
**F-75008 Paris (FR)**
Inventeur : **Chabbal, Jean**
**THOMSON-CSF SCPI 19, avenue de Messine**
**F-75008 Paris (FR)**

(74) Mandataire : **Guérin, Michel et al**
**THOMSON-CSF SCPI**
**F-92045 PARIS LA DEFENSE CEDEX 67 (FR)**

## Description

La présente invention concerne un capteur d'image à faible encombrement. Ce capteur s'applique notamment à l'endoscopie. Dans cette application, il est évidemment nécessaire que le capteur présente un encombrement aussi faible que possible, tout en conservant des performances électro-optiques : surface photosensible, résolution, sensibilité,... acceptables.

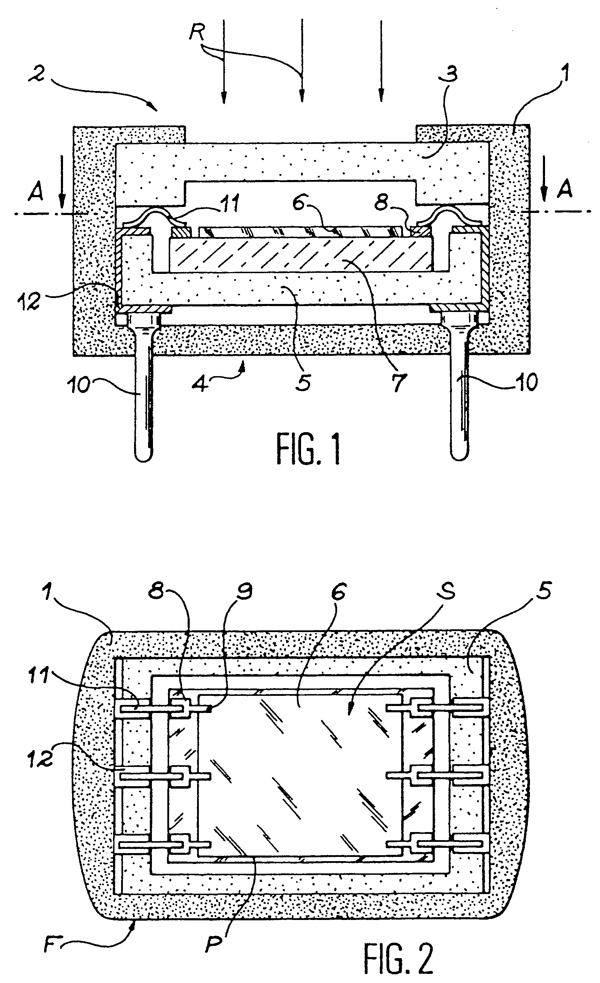

Les figures 1 et 2 représentent schématiquement un capteur d'image à faible encombrement, connu dans l'état de la technique. La figure 1 est une coupe schématique transversale de ce capteur, et la figure 2 est une coupe schématique AA du capteur de la figure 1. Les mêmes éléments portent les mêmes références sur les figures 1 et 2.

Ce capteur comporte un boîtier étanche 1 constitué dans un matériau électriquement isolant tel qu'une matière plastique moulée par exemple. Ce boîtier présente une face avant 2 munie d'une fenêtre 3 constituée dans un matériau électriquement isolant et transparent à des rayons lumineux R issus d'une partie d'un organe du corps humain ou d'un objet dont on veut obtenir une image. Le matériau constituant la fenêtre 3 est par exemple du verre ou une matière plastique transparent. Il est bien évident que lorsque ce capteur est utilisé pour obtenir des images de l'intérieur d'un organe humain, l'intérieur de cet organe est éclairé par une source de lumière indépendante du capteur.

Ce capteur présente aussi une face arrière 4, formant le fond du boîtier 1. Cette face arrière est parallèle à la face avant.

L'intérieur du boîtier contient, entre le fond 4 et la fenêtre 3, un empilement qui comporte un support isolant 5 constitué par exemple d'une céramique et un ensemble 6 d'éléments photosensibles à substrat semi-conducteur 7, représenté de manière non détaillée sur la figure.

Ce substrat peut être par exemple du silicium, tandis que les éléments photosensibles forment une matrice constituée de photodiodes éventuellement associées à des éléments à transfert de charges (en anglais "Charges Coupled Devices ou CCD).

Comme le montre plus précisément la figure 2, les éléments photosensibles forment une surface S délimitée par un pourtour P comportant des plots de connexions tels que 8. Ces plots sont reliés aux éléments photosensibles de l'ensemble 6, par exemple par des pistes de connexion telles que 9.

Ce capteur comporte aussi des moyens de connexion permettant de relier les plots 8 avec des bornes de connexion 10. Ces bornes de connexion traversent le fond 4 du boîtier 1. Ils comportent ici, pour chaque plot 8 chaque borne correspondante 10, un pontet conducteur 11 et une pièce conductrice intermédiaire 12. Le pontet conducteur 11 est métallique et élastique, en cuivre par exemple. Ce pontet est en contact avec le plot 8 et avec la pièce intermédiaire 12, elle-même en contact avec la borne 10. Cette pièce intermédiaire peut, elle aussi, être constituée en cuivre. La conduction électrique est ainsi établie entre la borne 10 et le plot 8. Les différentes bornes du capteur permettent l'alimentation électrique des éléments photosensibles correspondant aux différents plots. Les bornes 10 permettent aussi de recueillir les signaux électriques fournis par les éléments photosensibles, lorsque la surface photosensible S est éclairée par les rayons lumineux R. Les contacts électriques entre chaque plot 8, le pontet 11, la pièce intermédiaire 12 et la borne 10, sont assurés grâce à la pression mécanique exercée par le boîtier, lors de son moulage, sur la fenêtre 3.

Dans ce type de capteur, la surface photosensible S représente moins de la moitié de la surface frontale du boîtier 1 délimitée par son pourtour extérieur F. Pour un boîtier d'une surface frontale de 16 mm$^2$ par exemple, la surface photosensible S occupe seulement 43% de cette surface frontale. La partie restante est occupée de manière importante par l'ensemble des éléments de connexion (pontets 11, pièces intermédiaires 12) qui relient les plots 8 aux bornes correspondantes 10. Dans l'exemple considéré pour un boîtier ayant une surface frontale de 16 mm$^2$, le nombre de bornes 10 est limité à 6 et il est impossible d'accroître ce nombre sans augmenter la surface frontale du capteur, précisément à cause de la place trop importante qu'occupent les éléments de connexion dans le boîtier. L'augmentation de la surface frontale est impossible, notamment en endoscopie. Il en résulte que dans l'état actuel de la technique, on ne connaît pas de capteur qui pour le type de structure décrite, présente pour une même surface frontale, une surface photosensible beaucoup plus importante et un plus grand nombre de bornes de connexion. Ceci est un grave inconvénient car les performances de ce capteur sont limitées.

L'invention a précisément pour but de remédier à ces inconvénients en réalisant un capteur d'image à faible encombrement, dans lequel, sans accroître la surface frontale, il est possible d'augmenter de manière très importante la surface photosensible ainsi que le nombre de bornes de connexion. Ces buts sont atteints, comme on le verra plus loin en détail, grâce à un empilement judicieux à l'intérieur du boîtier et grâce à l'utilisation d'éléments de connexion beaucoup moins encombrants.

L'invention a pour objet un capteur d'image à faible encombrement, comportant un boîtier étanche constitué dans un matériau électriquement isolant, ce boîtier ayant une face avant munie d'une fenêtre constituée dans un matériau électriquement isolant et transparent à des rayons lumineux, et une face arrière formant le fond du boîtier et, dans ce boîtier, un empilement comportant entre le fond du boîtier et la fenêtre, un support isolant, un ensemble d'éléments photosensibles à substrat semi-conducteur, ces éléments photosensibles formant une surface photosensible délimitée par un pourtour comportant des plots de connexion avec les éléments photosensibles, et des moyens de connexions pour relier les plots de connexion avec des bornes de connexion permettant l'alimentation électrique des éléments photosensibles et permettant de recueillir des signaux électriques fournis par ces éléments lorsqu'ils sont éclairés, ces bornes de connexion traversant le fond du boîtier, caractérisé en ce que le substrat semi-conducteur est situé en regard de la fenêtre, les éléments photosensibles étant situés en regard du support isolant et recevant les rayons lumineux ayant traversé la fenêtre et le substrat, les bornes de connexion traversant le support isolant, pour déboucher par des extrémités respectives sur une face de ce support en regard de la surface photosensible et des plots de connexion, les moyens de connexion étant interposés entre lesdites extrémités des bornes et les plots de connexion correspondants.

Selon une autre caractéristique de l'invention, les moyens de connexion comprennent des entretoises constituées dans un matériau électriquement conducteur, interposées respectivement entre les extrémités des bornes et les plots correspondants, ces entretoises étant en contact avec ces extrémités et ces bornes.

Selon une autre caractéristique, lesdites entretoises sont des billes d'indium.

Selon une autre caractéristique, lesdites entretoises sont constituées par une colle conductrice.

Selon une autre caractéristique, les moyens de connexion comprennent une nappe isolante comportant des zones d'un matériau conducteur situées respectivement en regard desdits plots et des extrémités correspondantes desdites bornes.

Selon une autre caractéristique, ledit matériau conducteur est un métal.

Les caractéristiques et avantages de l'invention ressortiront mieux de la description qui va suivre, donnée en référence aux dessins annexés dans lesquels:

— la figure 1 a déjà été décrite et représente schématiquement et en coupe transversale, un capteur connu dans l'état de la technique,

— la figure 2 a déjà été décrite et représente schématiquement le capteur de la figure 1 en coupe AA,

— la figure 3 est une coupe transversale schématique d'un capteur conforme à l'invention,

— la figure 4 est une coupe BB schématique du capteur de la figure 3,

— la figure 5 représente schématiquement et en perspective l'un des moyens de connexion utilisé dans le capteur de l'invention.

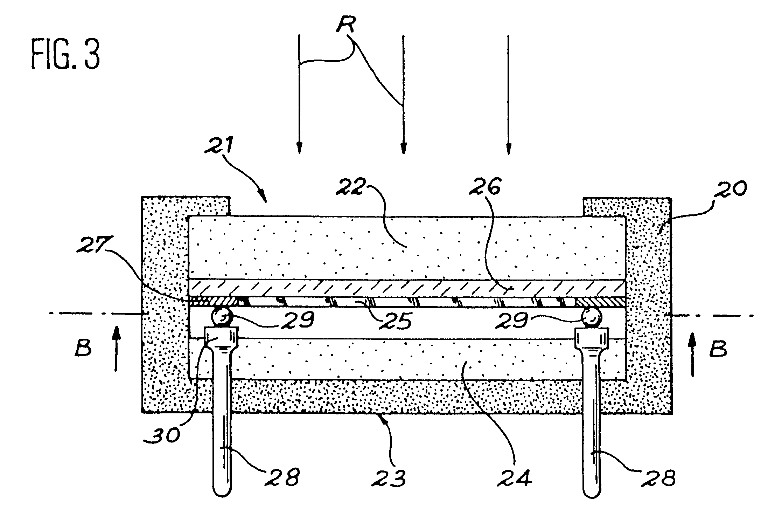

Le capteur conforme à l'invention, représenté schématiquement et en coupe transversale sur la figure 3, comporte un boîtier étanche 20 constitué dans un matériau électriquement isolant tel qu'une matière plastique par exemple. Ce boîtier présente une face avant 21 munie d'une fenêtre 22 constituée dans un matériau électriquement isolant et transparent, tel qu'une matière plastique ou du verre. L'étanchéité entre le boîtier 20 et la fenêtre 22 est assurée par des moyens appropriés, tels que le collage par exemple. La fenêtre 22 reçoit des rayons lumineux R provenant d'une partie de l'intérieur d'un objet ou d'un organe du corps humain. Une face arrière 23 de ce boîtier, parallèle à la fenêtre 22, constitue le fond du boîtier.

L'intérieur du boîtier contient, entre le fond 23 et la fenêtre 22, un empilement qui comporte un support isolant 24, en céramique par exemple, et un ensemble d'éléments photosensibles 25 à substrat semiconducteur 26.

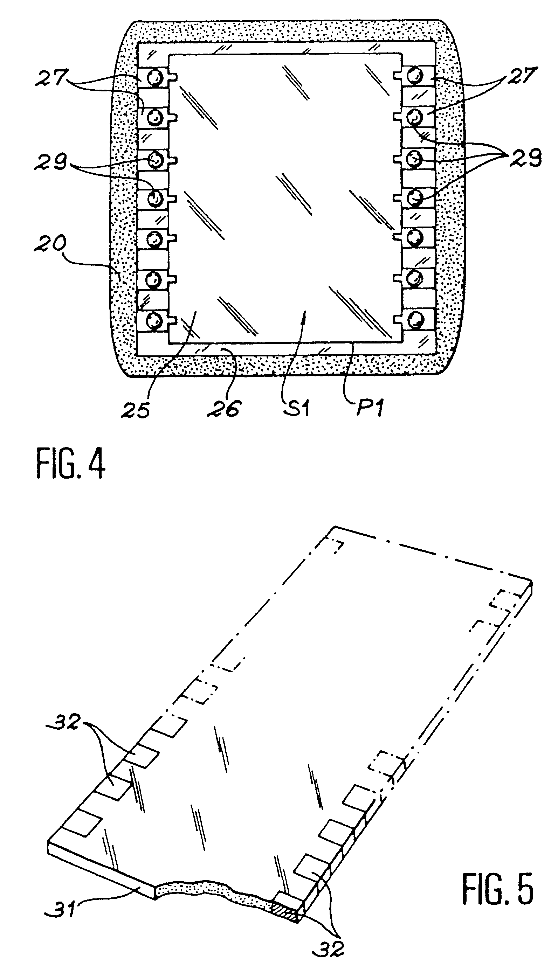

Les éléments photosensibles forment une surface photosensible S1 qui apparaît mieux sur la coupe BB de la figure 4. Cette surface est délimitée par un pourtour P1 comportant des plots tels que 27, de connexion avec les éléments photosensibles 25. Ces éléments ne sont pas représentés en détail. Ils peuvent être constitués par des photodiodes éventuellement associées à des dispositifs à transfert de charges (CCD) formant une matrice photosensible de surface S1.

Ce capteur comporte aussi des moyens de connexion pour relier les plots de connexion 27 avec des bornes de connexion 28 permettant l'alimentation électrique des éléments photosensibles et permettant de recueillir les signaux électriques fournis par ces éléments lorsqu'ils sont éclairés par les rayons lumineux R provenant de l'intérieur de l'objet ou de l'organe dont on veut obtenir l'image. Cette image est bien entendu obtenue par traitement des signaux recueillis sur les bornes 28. Les bornes de connexion 28 traversent le fond 23 du boîtier 20 et, traversent aussi, selon l'invention, le support isolant 24. Chaque extrémité 30 de chaque borne débouche du support isolant, sur la face de ce support qui est en regard des éléments photosensibles 25 et des plots 27.

Selon l'invention, le substrat semi-conducteur 26 (en silicium par exemple) est situé en regard de la fenêtre 22, tandis que les éléments photosensibles sont situés en regard du support isolant 24. Dans le capteur de type connu décrit plus haut, une disposition inverse est adoptée comme le montre la figure 1: le substrat semi-conducteur 7 est en regard du support isolant 5, tandis que les éléments photosensibles 6 sont en regard de la fenêtre 3. Il en résulte que dans le capteur connu, les rayons lumineux R sont directement reçus par les éléments photosensibles 6, après avoir traversé la fenêtre 3, alors que dans le capteur de l'invention (figures 3 et 4), les rayons lumineux R sont reçus par les éléments photosensibles 25, après avoir traversé la fenêtre 22 et le substrat semi-conducteur 26 obtenu par amincissement du substrat semi-conducteur standard et qui présente ici une épaisseur bien plus faible que pour le capteur connu (10 à 15 µm au lieu de plusieurs dizaines de microns). C'est précisément cette disposition inverse qui permet d'accroître de manière très importante la surface photosensible à l'intérieur du boîtier, comme le montre la figure 4. Les plots de connexion 27 sont en effet situés en regard du fond du boîtier et des bornes de connexion 28 correspondantes, ce qui permet comme on le verra plus loin en détail, de diminuer l'encombrement des moyens de connexion permettant de relier respectivement ces plots et ces bornes.

Les moyens de connexion sont ici respectivement interposés entre ces plots 27 et les bornes 28 qui leur correspondent.

Dans un premier mode de réalisation du capteur de l'invention, tel que représenté sur les figures 3 et 4, ces moyens de connexion comprennent des entretoises 29 constituées dans un matériau conducteur, ces entretoises étant respectivement interposées entre les plots 27 et les extrémités 30 des bornes 28 correspondantes. Chaque entretoise est en contact avec l'extrémité 30 de la borne correspondante 28, grâce à la pression mécanique exercée par le boîtier sur la fenêtre 22 qui elle-même appuie sur le substrat 26. Ces entretoises peuvent être constituées, dans ce mode de réalisation, par des billes d'indium obtenues par croissance sous vide sur les plots 27. Lorsque le boîtier est moulé autour de l'empilement, ces billes s'écrasent légèrement grâce à la pression mécanique que le boîtier exerce sur la fenêtre, et un bon contact électrique est ainsi assuré entre ces billes et les extrémités 30 des bornes 28.

Ces entretoises peuvent aussi être constituées par une colle conductrice, telle qu'une résine époxy chargée d'argent par exemple.

La figure 5 représente schématiquement et en perspective, un autre mode de réalisation des moyens de connexion interposés entre les plots 27 et les extrémités 30 des bornes 28. Dans ce mode de réalisation, ces moyens de connexion sont constitués par une nappe isolante 31 qui comporte des zones 32 d'un matériau conducteur. Ces zones sont respectivement situées en regard des plots 27 et des extrémités 30 des bornes 28 correspondantes. Les zones conductrices sont métalliques (en cuivre par exemple). La nappe isolante 31 peut être constituée dans un matériau élastomère. Elle est interposée, lors du montage du capteur, entre l'ensemble d'éléments photosensibles 25 et les extrémités 30 des bornes 28. La pression exercée par le boîtier sur la fenêtre 22 permet d'assurer un bon contact entre les zones conductrices 32, les extrémités 30 des bornes 28 et les plots 27.

Grâce à la structure qui vient d'être décrite, la surface S1 de l'ensemble d'éléments photosensibles peut être au moins deux fois plus importante que la surface S de ces éléments dans le capteur connu. Il en est de même pour le nombre de bornes de connexion qui est bien plus important que dans le capteur connu. Ces buts sont atteints sans modification de la surface frontale du capteur.

## Revendications

1. Capteur d'image à faible encombrement, comportant un boîtier étanche (20) constitué dans un matériau électriquement isolant, ce boîtier ayant une face avant (21) munie d'une fenêtre (22) constituée dans un matériau électriquement isolant et transparent à des rayons lumineux (R), et une face arrière (23) formant le fond du boîtier et, dans ce boîtier, un empilement comportant entre le fond (23) du boîtier et la fenêtre (22), un support isolant (24), un ensemble (25) d'éléments photosensibles à substrat semi-conducteur (26), ces éléments photosensibles formant une surface photosensible (S1) délimitée par un pourtour (P1) comportant des plots de connexion (27) avec les éléments photosensibles, et des moyens de connexions pour relier les plots de connexion (29 ou 31, 32) avec des bornes de connexion (28) permettant l'alimentation électrique des éléments photosensibles (25) et permettant de recueillir des signaux électriques fournis par ces éléments lorsqu'ils sont éclairés, ces bornes de connexion (28) traversant le fond du boîtier, caractérisé en ce que le substrat semi-conducteur (26) est situé en regard de la fenêtre (22), les éléments photosensibles (25) étant situés en regard du support isolant (24) et recevant les rayons lumineux ayant traversé la fenêtre (22) et le substrat (25), les bornes de connexion (28) traversant le support isolant (24), pour déboucher par des extrémités respectives (30) sur une face de ce support en regard de la surface photosensible (S1) et des plots de connexion (27), les moyens de connexion (29 ou 31, 32) étant interposés entre lesdites extrémités (30) des bornes (28) et les plots de connexion (27) correspondants.

2. Capteur d'image selon la revendication 1, caractérisé en ce que les moyens de connexion (29) comprennent des entretoises constituées dans un matériau électriquement conducteur, interposées respectivement entre les extrémités (30) des bornes (28) et les plots (27) correspondants, ces entretoises étant en contact avec ces extrémités et ces bornes.

3. Capteur selon la revendication 2, caractérisé en ce que lesdites entretoises (29) sont des billes d'indium.

4. Capteur selon la revendication 2, caractérisé en ce que lesdites entretoises (29) sont constituées par une colle conductrice.

5. Capteur selon la revendication 1, caractérisé en ce que les moyens de connexion comprennent une nappe isolante (31) comportant des zones (32) d'un matériau conducteur situées respectivement en regard desdits plots (27) et des extrémités (30) correspondantes desdites bornes (28).

6. Capteur selon la revendication 5, caractérisé en ce que ledit matériau conducteur est un métal.

## Ansprüche

1. Bildaufnehmer mit geringem Raumbedarf, der ein hermetisches Gehäuse (20), das aus einem elektrisch isolierenden Material besteht, wobei dieses Gehäuse eine Vorderfläche (21), die mit einem aus einem elektrisch isolierenden Material bestehenden und für Lichtstrahlen (R) durchsichtigen Fenster (22) versehen ist, sowie eine Rückfläche (23) aufweist, die den Boden des Gehäuses bildet, sowie in diesem Gehäuse einen Stapel, der zwischen dem Boden (23) des Gehäuses und dem Fenster (22) einen isolierenden Träger (24), eine Gruppe (25) lichtempfindlicher Elemente mit halbleitendem Substrat (26), wobei diese lichtempfindlichen Elemente eine lichtempfindliche Fläche (S1) bilden, die von einem Umfang (P1) begrenzt wird, der Klötzchen (27) zum Anschließen an den lichtempfindlichen Elementen enthält sowie Anschlußmittel umfaßt, um die Anschlußklötzchen (29 oder 31, 32) mit den Anschlußklemmen (28) zu verbinden, die die elektrische Versorgung der lichtempfindlichen Elemente (25) und das Sammeln der von diesen Elementen abgegebenen elektrischen Signale, wenn sie beleuchtet sind, ermöglichen, wobei diese Anschlußklemmen (28) den Boden des Gehäuses durchqueren, dadurch gekennzeichnet, daß das halbleitende Substrat (26) dem Fenster (22) gegenüberliegt, wobei die lichtempfindlichen Elemente (25) dem isolierenden Träger (24) gegenüberliegen und die Lichtstrahlen empfangen, die das Fenster (22) und das Substrat (25) durchquert haben, wobei die Anschlußklemmen (28) den isolierenden Träger (24) durchqueren, um an den jeweiligen Enden (30) in eine Fläche dieses Trägers gegenüber der lichtempfindlichen Fläche (S1) und den Anschlußklötzchen (27) zu münden, wobei die Anschlußmittel (29 oder 31, 32) zwischen den genannten Enden (30) der klemmen (28) und den entsprechenden Anschlußklemmen (27) eingefügt sind.

2. Bildaufnehmer nach Anspruch 1, dadurch gekennzeichnet, daß die Anschlußmittel (29) Stützen umfassen, die aus einem elektrisch leitenden Material gebildet sind, die jeweils zwischen den Enden (30) der klemmen (28) und den entsprechenden klötzchen (27) eingefügt sind, wobei diese Stützen diese Enden und diese klemmen berühren.

3. Bildaufnehmer nach Anspruch 2, dadurch gekennzeichnet, daß diese Stützen (29) Indium-kugeln sind.

4. Bildaufnehmer nach Anspruch 2, dadurch gekennzeichnet, daß die Stützen (29) aus einem leitenden klebstoff gebildet sind.

5. Bildaufnehmer nach Anspruch 1, dadurch gekennzeichnet, daß die Anschlußmittel eine Isolierbahn (31) umfassen, welche Bereiche (32) aus einem leitenden Material, die gegenüber den genannten klötzchen (27) und den entsprechenden Enden (30) der genannten klemmen (28) liegen, aufweisen.

6. Bildaufnehmer nach Anspruch 5, dadurch gekennzeichnet, daß das genannte leitende Material ein Metall ist.

## Claims

1. A compact image sensor, comprising a sealed enclosure (20) manufactured of an electrically insulating material, said enclosure having a front face (21) provided with a window (22) made of an electrically insulating material transparent to light radiation (R), and a rear face (23) forming the end of the enclosure and, in the said enclosure, a stack comprising between the end (23) of the enclosure and the window (22) an arrangement (25) of photosensitive elements having a semiconductor substrate (26), said photosensitive elements forming a photosensitive surface (S1) delimited by a surround (P1) comprising connection studs (27) connected with the photosensitive elements, and connection means in order to connect the connection studs (29 or 31 and 32) with connection terminals (28) making possible the electrical supply of the photosensitive elements (25) and making it possible to receive electrical signals yielded by these elements, when the same are illuminated, said connection terminals (28) extending through the end of the enclosure, characterized in that the semiconductor substrate (26) is placed opposite the window (22) the photosensitive elements (25) being placed opposite the insulating support (24) and receiving the light radiation coming through the window (22) and the substrate (25), the connection terminals (28) extending through the insulating support (24) in order to come out through the respective ends (30) at one face of this support opposite to the photosensitive surface (S1) and connection studs (27), the connection means (29 or 31 and 32) being placed between the said ends (30) of the terminals (28) and the corresponding connection studs (27).

2. The image sensor as claimed in claim 1, characterized in that the connection means (29) comprises spacers made of an electrically conductive material, placed respectively between the ends (30) of the terminals (28) and the corresponding studs (27), said spacers being in contact with these ends and these terminals.

3. The image sensor as claimed in claim 2, characterized in that the said spacers (29) are indium balls.

4. The image sensor as claimed in claim 2, characterized in that the said spacers (29) are in the form of a conductive adhesive.

5. The image sensor as claimed in claim 1, characterized in that the connection means comprises a insulating sheet (31) having zones (32) of conducive material placed respectively opposite the said studs (27) and corresponding ends (30) of the said terminals (28).

6. The image sensor as claimed in claim 5, characterized in that the conductive material is a metal.

FIG. 1

FIG. 2

FIG. 3

EP 0 325 525 B1

FIG. 4

FIG. 5